# EUROPÄISCHE PATENTSCHRIFT

(11) **EP 1 683 210 B1**
(45) Veröffentlichungstag und Bekanntmachung des Hinweises auf die Patenterteilung: **09.01.2019**
(21) Anmeldenummer: 04802725.4
(22) Anmeldetag: 12.11.2004
(51) Int. Cl.: H01L 27/32, H01L 51/50, H01L 51/00

(54) **VOLLFARBIGE ORGANISCHE ANZEIGE MIT FARBFILTERTECHNOLOGIE UND ANGEPASSTEM WEISSEN EMITTERMATERIAL SOWIE VERWENDUNGEN DAZU**
FULL COLOUR ORGANIC DISPLAY WITH COLOUR FILTER TECHNOLOGY WITH SUITABLE WHITE EMITTER MATERIAL AND APPLICATIONS THEREOF
AFFICHAGE ORGANIQUE EN COULEURS A FILTRE COULEUR ET MATIERE EMETTRICE BLANCHE ADAPTEE ET UTILISATIONS DUDIT AFFICHAGE

(30) Priorität: 13.11.2003 DE 10353036
(43) Veröffentlichungstag der Anmeldung: 26.07.2006
(73) Patentinhaber: OSRAM OLED GmbH, 93049 Regensburg (DE)
(72) Erfinder: BUCHHAUSER, Dirk, 93051 Regensburg (DE); HENSELER, Debora, 91052 Erlangen (DE); HEUSER, Karsten, 91056 Erlangen (DE); ROGLER, Wolfgang, 91096 Möhrendorf (DE)
(74) Vertreter: Epping - Hermann - Fischer
(86) Internationale Anmeldenummer: PCT/DE2004/002509
(87) Internationale Veröffentlichungsnummer: WO 2005/048366

(56) Entgegenhaltungen:
- GB-A- 2 330 454
- US-A1- 2003 127 968
- PATENT ABSTRACTS OF JAPAN Bd. 1998, Nr. 06, 30. April 1998 (1998-04-30) -& JP 10 039791 A (MITSUBISHI ELECTRIC CORP; IDEMITSU KOSAN CO LTD), 13. Februar 1998 (1998-02-13)

## Beschreibung

Die Erfindung betrifft eine vollfarbige organische Leuchtanzeige (Organic Ligh Emitting Diode-Anzeige, kurz "OLED-Anzeige") mit verbesserter Farbstabilität, insbesondere eine Leuchtanzeige, bei der die Farben durch Farbfilter, die vor einem Emitter angeordnet sind, erzeugt werden. Außerdem betrifft die Erfindung die Verwendung solcher OLED-Anzeigen, beispielsweise im Bereich Kommunikation, Automotive, Consumer-Elektronik, Business, Medizintechnik, industrielle Elektronik oder Haushaltsgeräte.

Bekannt sind OLEDs, beispielsweise zur Herstellung vollfarbiger Displays, die folgendermaßen aufgebaut sind: Auf ein mit ITO (Indium Tin Oxide) beschichtetes Substrat wird eine Emitterschicht aufgebracht, oftmals auf einer zusätzlichen planarisierenden und/oder lochtransportierenden Zwischenschicht. Die Emitterschicht kann entweder in Pixel (Einzelpunkte) strukturiert sein und aus verschieden emittierenden Materialien bestehen (typischerweise rot, grün und blau) oder aus einem einheitlich emittierendem Material, wobei die einzelnen Farbpixel durch vorgeschaltete Farbfilter erzeugt werden (Farbfiltertechnologie). Um hierbei auf der Anzeige eine vorgegebene Farbe (z.B. den Weißpunkt) zu erreichen, werden die Subpixel der einzelnen Farben mit einem bestimmten Stromverhältnis getrieben, das von dem Emittermaterial und den Farbfiltern abhängt.

Alle Farben, die ein Mensch erkennen kann, sind beispielsweise durch einen Bereich im sogenannten CIE-Diagramm definiert. Innerhalb dieser Fläche können Segmente oder Untermengen abgesteckt werden, die die Farben eingrenzen, die für den Aufbau eines vollfarbigen Displays ausreichen. Umschlossen ist von dieser Untermenge in jedem Fall der sogenannte white point oder Weißpunkt, an dem die Anzahl und Intensität der jeweiligen Subpixel so gewählt ist, dass die Farbe weiß emittiert wird.

Um eine weiße Emission bei organischen Leuchtdioden zu erzielen, werden beispielsweise in aktuellen Vollfarb-Displays mit strukturieren Emitterschichten die Subpixel rot, grün und blau mit einem Intensitäts-Verhältnis von 1.2 (rot) zu 1(grün) zu 1.8 (blau) betrieben. Das heißt, dass die blauen Subpixel fast mit der doppelten Stromdichte getrieben werden wie die grünen. Unter der Voraussetzung, dass die einzelnen Subpixel-Sätze bei gängigen Anwendungen von vollfarbigen Displays im Mittel so getrieben werden, dass als durchschnittliche Farbe der Weißpunkt wiedergegeben wird, altern die blauen Subpixel auch etwa doppelt so schnell wie die grünen. Als Resultat ändert sich die tatsächlich angezeigte Farbe bei einem alternden Display.

In US 2003/127968 A1 sind organische elektrolumineszierende Elemente mit Farbfiltern offenbart.

Aus GB 2 330 454 A ist eine polychromatische Elektrolumineszenz-Anordnung, die einen mehrschichtigen Farbkonversionsfilter umfasst, bekannt.

Die JP 10-039791 A beschreibt ein OLED-Display, mit Farbkonversionsfiltern.

Eine Aufgabe der vorliegenden Erfindung ist es daher, ein vollfarbiges Display zu schaffen, bei dem gleichbleibende Farben über die gesamte Lebensdauer der organischen Anzeige mit Farbfiltertechnologie erhalten bleiben.

Diese Aufgabe wird durch ein farbiges Display mit den Merkmalen des Patentanspruches 1 gelöst. Vorteilhafte Weiterbildungen und Verwendungen sind in den abhängigen Ansprüchen angegeben.

Gegenstand der Erfindung ist eine farbige organische Anzeige (OLED-Display) mit Pixeln, die jeweils einen Subpixel-Satz mit den Farben Rot, Grün und Blau umfassen, wobei die einzelnen Subpixel ein identisches Emittermaterial enthalten, mit:
- einem Substrat, das zumindest teilweise durchlässig für sichtbares Licht ist,
- einem strukturierten Farbfilter, der die Farben der Subpixel erzeugt und nachfolgend auf das Substrat angeordnet ist,
- einer ersten Elektrode nachfolgend auf den Farbfilter, die zumindest teilweise durchlässig für sichtbares Licht ist,
- mindestens einer aktiven Schicht nachfolgend auf die erste Elektrode, die ein Emittermaterial enthält, wobei das Emittermaterial Polymere mit Chromophoren, die einen blauen Farbeindruck erzeugen, enthält und erste Chromophore, die einen grünen Farbeindruck erzeugen, und zweite Chromophore, die einen roten Farbeindruck erzeugen, umfasst, und das geeignet ist, elektromagnetische Strahlung zu erzeugen, dessen Spektrum durch den Anteil der jeweiligen Chromophore so auf das Transmissionsspektrum des Farbfilters abgestimmt ist, dass die Pixel bei Ansteuerung mit einem gleichen elektrischen Signal Licht aussenden, dessen Farbort im weißen Bereich des CIE-Diagramms liegt, und
- einer zweiter Elektrode nachfolgend auf die aktive Schicht.

Bei einer bevorzugten Ausführungsform fungiert die erste Elektrode als Anode und umfasst Indium-Zinn-Oxid (ITO), da ITO ein Material mit hoher Austrittsarbeit für Elektronen und im Wesentlichen durchlässig für sichtbares Licht ist.

Gemäß der vorliegenden Erfindung umfassen die Subpixel alle das gleiche Emittermaterial und der unterschiedliche Farbeindruck, rot, grün und blau wird durch einen strukturierten Farbfilter erzeugt. Der Farbfilter ist so strukturiert, dass er im Bereich der Subpixel Transmission für sichtbares Licht der jeweils gewünschte Farbe zeigt. Dies bietet gegenüber farbigen Displays mit Subpixel aus verschiedenfarbige Emittern produktionstechnische Vorteile, da nur ein Material verarbeitet werden muss. Weiterhin spielt es bei Verwendung eines einheitlichen Emittermaterials für die Qualität des Displays keine Rolle, wenn sich Emittermaterial verschiedener Subpixel geringfügig vermischt.

Erfindungsgemäß wird ein maßgeschneiderter Breitband-Emitter, der jeweils auf die Durchlässigkeit der Farbfilter abgestimmt ist, eingesetzt. Diese Kombination ermöglicht es erstmals, alle drei Subpixel-Sätze mit der gleichem Strom oder Intensität oder Helligkeit zu betreiben und überkommt damit das Problem der ungleichen Alterung/Lebensdauer der Subpixel-Sätze, das bislang sowohl bei den Tintenstrahldruckverfahren als auch bei den Breitbandemittern, die großflächig aufgetragen werden und mittels Farbfilter verschieden farbig emittieren, besteht und große Schwierigkeiten bei der Realisierung vollfarbiger Displays verursacht. Aufgrund der unterschiedlichen Transmission der einzelnen Farbfilter werden diese Subpixel nach dem Stand der Technik alle mit verschiedener Stromstärke getrieben.

Da das Emittermaterial so auf das Spektrum des Farbfilters ausgelegt ist, dass alle Subpixel mit dem gleichen elektrischen Signal betrieben werden können, altert das aktive Material der Emitterschicht gleichartig. Vorteilhafterweise bleibt daher der Farbeindruck der Anzeige mit der Betriebsdauer im Wesentlichen konstant.

Durch das Treiben der drei Subpixel-Sätze mit gleichem Strom wird erreicht, dass die Pixel eines vollfarbigen Displays bei durchschnittlich gleichmäßiger Ansteuerung der verschiedenen Farben ungefähr eine gleiche Lebensdauer haben.

Die für ein Pixel im Betrieb verwendete Stromdichte hat einen unmittelbaren Einfluss auf die Lebensdauer des Emittermaterials. So sinkt die Lebensdauer eines Pixels mindestens um einen Faktor 2, wenn die Helligkeit des Pixels durch Erhöhung der Stromdichte um den Faktor 2 gesteigert wird.

Es ist Gegenstand der Erfindung eine OLED-Anzeige deren einzelne Subpixel des Subpixel-Satzes rot, grün und blau die gleiche Lebensdauer haben.

Bei einer Ausführungsform der farbigen organischen Anzeige enthält das Emittermaterial Polymere mit ersten Chromophoren, die einen grünen Farbeindruck vermitteln und zweite Chromophore, die einen roten Farbeindruck vermitteln. Die ersten (grünen) Chromophoren und die zweiten (roten) Chromophoren können den Polymeren zugemischt (sog. Polymer blends) oder kovalent an diese gekoppelt sein.

Bevorzugt werden bei dieser Ausführungsform blau emittierende Polymere als Emittermaterial verwendet, wie beispielsweise Polyspiro- oder Polyfluorenverbindungen, an die rote und grüne Chromophore kovalent gekoppelt werden. Durch das kovalente Koppeln roter und grüner Chromophore an die blau emittierenden Polymere werden weiß emittierende Copolymere erzeugt.

Es ist auch denkbar die Chromophore an unterschiedliche Polymere zu koppeln und diese zu mischen. Der Anteil der jeweiligen Chromophoren ist bevorzugt so gewählt, dass das Emissionsspektrum des Emittermaterials an das Transmissionsspektrum des Farbfilters so angepasst ist, dass die Subpixel mit dem gleichen elektrischen Signal angesteuert werden können.

Bei einer bevorzugten Ausführungsform der farbigen organischen Anzeige enthält das Emittermaterial weiterhin Chromophore, die einen blauen Farbeindruck erzeugen. Mit Hilfe zusätzlicher blauer Chromophoren kann das Emissionsspektrum des Emittermaterials besonders einfach und genau an das Transmissionsspektrums eines Farbfilters zur Erzeugung roter, grüner und blauer Subpixel angepasst werden.

Schließlich ist Gegenstand der Erfindung die Verwendung einer organischen Anzeige mit Farbfiltertechnologie nach der Erfindung, beispielsweise im Bereich Kommunikation, Automotive, Consumer-Elektronik, Business, Medizintechnik, industrielle Elektronik oder Haushaltsgeräte

Im folgenden wird die Erfindung anhand der folgenden Ausführungsbeispiele in Verbindung mit den Figuren 1 bis 4 und 5a bis 5d erläutert.

Es zeigen:
Figur 1, schematische Schnittansicht durch ein farbiges Display gemäß der Erfindung,
Figur 2, das CIE-Diagramm,
Figur 3, Transmissionsspektren zweier Filtersätze #1 und #2,
Figur 4, Emissionsspektrum eines Breitbandemitters mit roten und grünen Chromophoren, die an ein blau emittierendes Polymer kovalent gekoppelt sind, und
Figuren 5a bis 5d, chemische Strukturen der farbgebenden Untereinheiten und einer lochtransportierende Untereinheit eines Emittermaterials.

In den Ausführungsbeispielen und den Figuren sind gleiche oder gleich wirkende Bestandteile jeweils mit den gleichen Bezugszeichen versehen. Die dargestellten Elemente der Figuren, insbesondere die Schichtdicken, sind nicht als maßstabsgerecht anzusehen. Vielmehr können sie zum besseren Verständnis teilweise übertrieben groß dargestellt sein.

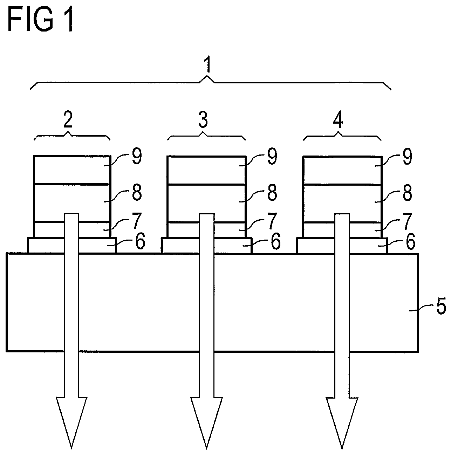

Bei dem Ausführungsbeispiel gemäß Figur 1 unterteilt sich jeweils ein Pixel 1 der farbigen organischen Anzeige in ein rotes 2, ein grünes 3 und ein blaues 4 Subpixel. Hierzu ist auf einem Substrat 5 ein strukturierter Farbfilter 6 aufgebracht. Das Substrat 5 ist im Wesentlichen durchsichtig für sichtbares Licht und besteht beispielsweise aus Glas. Insbesondere für flexible Anwendungen können aber auch Substrate aus lichtdurchlässigen Kunststoffen, wie beispielsweise Poly(ethylenterephthalat) (PET), Poly(butylenterephthalat) (PBT), Poly (enthylennaphthalat) (PEN), Polycarbonat (PC), Polyimid (PI), Polysulfon (PSO), Poly (p-Phenylenethersulfon) (PES), Polyethylen (PE), Polypropylen (PP), Poly(vinylchlorid) (PVC), Polystyrol (PS) und Poly(methylmethylacrylat) (PMMA) verwendet werden.

Der strukturierte Farbfilter 6 weist unterschiedliche Felder auf, die jeweils Licht mit der gewünschte Farbe des Subpixels 2, 3, 4 transmittieren. Diese Felder umfassen beispielsweise Polyacrylate, die mit Pigmenten versehen sind um den gewünschten Farbeindruck zu erzeugen. Diese Materialien können beispielsweise nasschemisch durch photolithographische Prozesse aufgebracht werden.

Auf dem strukturierten Farbfilter 6 ist eine Anode 7 aus Indium-Zinn-Oxid (ITO) aufgebracht. Diese kann ganzflächig oder strukturiert, beispielsweise entsprechend den Felder des Farbfilters 6 ausgebildet sein. ITO wird beispielsweise durch Sputtern aufgebracht.

Nachfolgend auf die Anode 7 ist eine aktive Schicht 8 angeordnet, die ein Emittermaterial umfasst. Nachfolgend auf die aktive Schicht 8 folgt eine Kathode 9, die vorzugsweise aus einem Material mit geringer Austrittsarbeit für Elektronen gefertigt ist. Die Kathode 9 kann beispielsweise Magnesium oder Calzium umfassen. Zwischen der aktiven Schicht 8 und den Elektroden können auch weitere Schichten, wie beispielsweise lochtransportierende oder elektronentransportierende Schichten angeordnet sein.

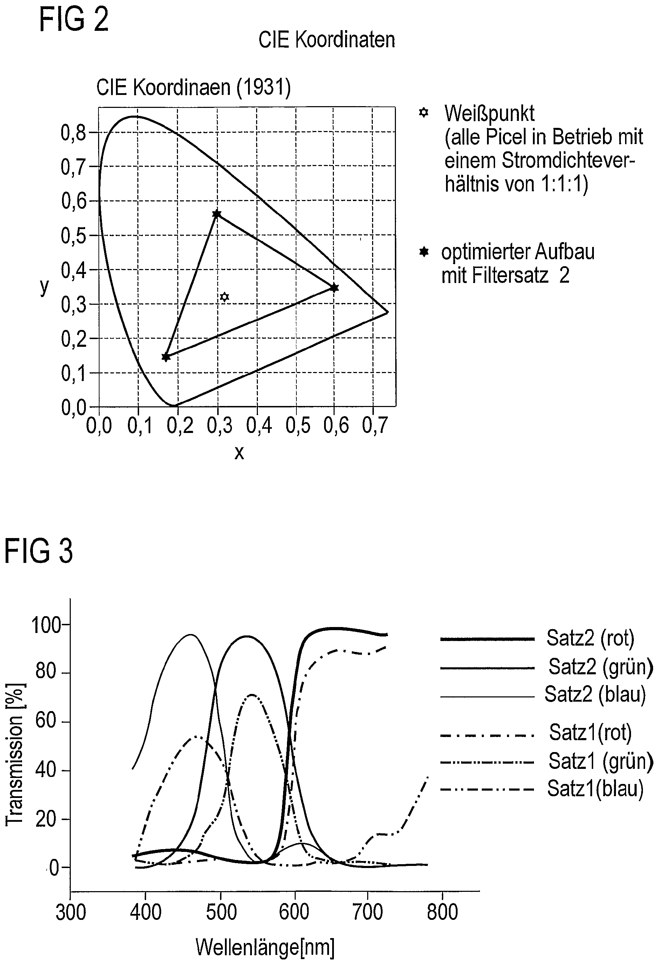

Figur 2 zeigt die CIE Koordinaten aller für den Menschen sichtbaren Farben und als Ausschnitt daraus ein Dreieck, das ungefähr die Menge an Farben umschließt, die beispielsweise ein Farbfernseher nach heutigen Ansprüchen wieder zu geben in der Lage sein soll.

Diese Untermenge umschließt den sogenannten Weißpunkt, der definitionsgemäß bei den CIE-Koordinaten x=0,33 / y=0,33 liegt. Ein Maß für die Gleichmäßigkeit der Farbwiedergabe in einem vollfarbigen Display ist die Entfernung des Mischpunktes, der bei gleicher Ansteuerung der Subpixel-Sätze entsteht, vom Weißpunkt.

Für die meisten üblichen Farbfiltersysteme ist es wünschenswert, dass das Emittermaterial so angepasst ist, das der Rot-Grün-Blau-(RGB)-Mischpunkt bei gleichmäßiger Ansteuerung auf dem Weißpunkt (x=0,33 / y=0,33) liegt (Figur 2). Je nach Transmissionsspektrum der Filter kann jedoch auch ein anderer Farbort angestrebt werden.

Figur 3 zeigt die Transmission zweier Farbfiltersätze 6 für rot, grün und blau, die gestrichelte Linie zeigt eine aufeinander abgestimmte Kombination aus Emittermaterial und einem Filtersatz (filter set) #1, das aus handelsüblichen Filtern besteht.

Die durchgezogenen Linien in Figur 3 geben die Transmission einer aufeinander abgestimmten Kombination aus Emittermaterial und Filtersatz #2 (rot, grün und blau umfassend) wieder, die bei gleichmäßiger Ansteuerung, also gleichen Treiberbedingungen, zusammen weiß am Punkt (0,33; 0,33) erzeugt.

Der Filtersatz #2 wurde optimiert im Hinblick auf bessere Durchlässigkeit, so dass bei gleicher Stromdichte eine höhere Transmission eine größere Helligkeit ermöglicht. Für den Filtersatz #1 siehe Figur 3, dort die gestrichelten Linien, wurde eine Auswahl an handelsüblichen Filtern gewählt.

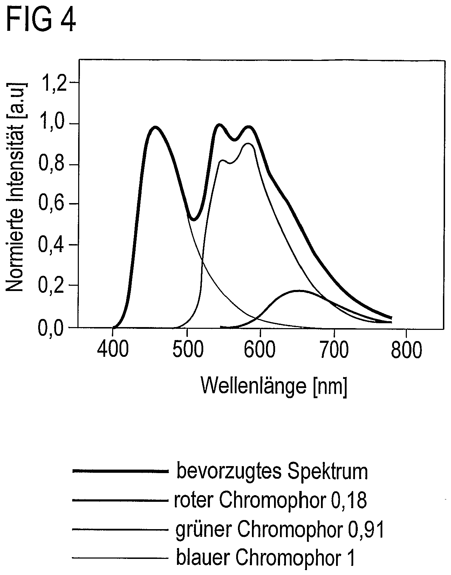

Figur 4 zeigt ein an den Farbfiltersatz #2 angepasstes Emissionsspektrum des organischen Emitters. Das Emittermaterial besitzt ein breitbandiges Emissionsspektrum, das beispielsweise drei breitbandige Komponenten Rot, Grün und Blau mit Maxima bei ca. 450, 580 und 640 nm umfasst.

Die in Figur 4 gezeigte Emissionscharakteristik erhält man beispielsweise bei organischen Emittermaterialien (auf Basis kleiner Moleküle oder Polymere, und dort Blends oder Kopolymere), die aus rot, grün und blau emittierenden Strukturelementen aufgebaut sind. Bekannt sind unter anderem Polyspiro-
oder Polyfluorene, die über diese rot, grün und blau emittierenden Strukturelemente beispielsweise eine in Figur 3 gezeigte breitbandige Emissionscharakteristik aufweisen. Das Material enthält die zumindest drei Chromophore 10, 11, 12 entweder in Form von Polymeren und/oder blends von Polymeren und deren Kopolymeren oder in Form von small molecules. Small molecules werden beispielsweise mit einer Aufdampftechnik aufgebracht, wohingegen die polymeren Emittermaterialien beispielsweise durch Aufschleudern oder Drucktechniken aufgebracht werden.

Eine Anpassung der Chromophorenverhältnisse auf die Farbfiltersätze 6 gemäß der vorliegen Erfindung führt zu einem optimalen Verhältnis der Peak-Intensitäten von 0,18 (rot) zu 0,91 (grün) zu 1 (blau) für den Filtersatz #2 .

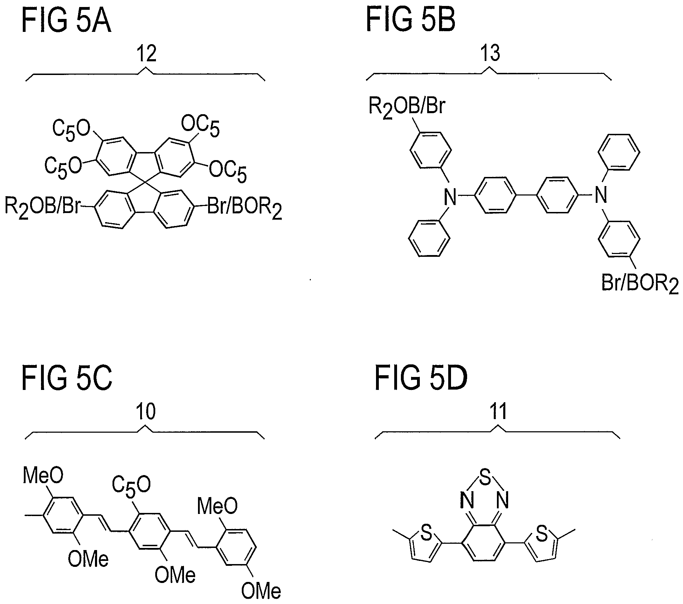

Als breitbandiges Emittermaterial werden gemäß eines Ausführungsbeispiels Kopolymere eingesetzt, die folgende farbgebende Untereinheiten (Chromophore) 10, 11, 12 umfassen: blau emittierende Spirobifluoreneinheiten 12 (vergleiche Figur 5a), grün emittierende Phenylenvinylen Oligomereinheiten (OPV) 10 (vergleiche Figur 5c) und rot emittierende Einheiten 11 (vergleiche Figur 5d). Weiterhin umfasst das Emittermaterial kovalent gekoppelte lochtransportierende Einheiten 13 (vergleiche Figur 5b).

Durch Variation des Gehaltes der einzelnen Chromophore 10, 11, 12 kann der Farbort des emittierten Lichtes innerhalb des Bereiches, der durch die Farborte der einzelnen Chromophoren 10, 11, 12 innerhalb des CIE-Diagramms aufgespannt wird, eingestellt werden.

Um ein Emittermaterial zu erhalten, dass Licht mit einem Farbort nahe des Weißpunktes (0.33; 0.33) zu erhalten, werden beispielsweise ca. 1% grün emittierende OPV-Einheiten 10 und ca. 1% rot emittierende Einheiten 11 an Kopolymere aus blau emittierende Spirobifluoreneinheiten 12 und lochtransportierende Einheiten 13 kovalent gekoppelt. Dieses Emittermaterial kann beispielsweise durch Druckverfahren, wie Siebdruckverfahren oder Spincoating aufgebracht werden.

Die Erfindung stellt erstmals eine organische Anzeige mit Farbfiltertechnologie zur Verfügung, die durch gleichmäßige Ansteuerung das Problem der ungleichen Alterung der Subpixel 2, 3, 4 überwindet.

Der Umfang der Erfindung ist nicht durch die Beschreibung der Erfindung anhand der Ausführungsbeispiele beschränkt. Vielmehr umfasst die Erfindung jede Kombination von Merkmalen in den Patentansprüchen, auch wenn diese Kombination nicht explizit in den Patentansprüchen angegeben ist.

## Patentansprüche

1. Farbige organische Anzeige (OLED-Display) mit Pixeln (1), die jeweils einen Subpixel-Satz (2, 3, 4) mit den Farben Rot, Grün und Blau umfassen, wobei die einzelnen Subpixel (2, 3, 4) ein identisches Emittermaterial enthalten, mit:
- einem Substrat (5), das zumindest teilweise durchlässig für sichtbares Licht ist,
- einem strukturierten Farbfilter (6), der die Farben der Subpixel (2, 3, 4) erzeugt und nachfolgend auf das Substrat (5) angeordnet ist,
- einer ersten Elektrode (7, 9) nachfolgend auf den Farbfilter (6), die zumindest teilweise durchlässig für sichtbares Licht ist,
- mindestens einer aktiven Schicht (8) nachfolgend auf die erste Elektrode (7, 9), die das Emittermaterial enthält, wobei das Emittermaterial Polymere mit Chromophoren (12), die einen blauen Farbeindruck erzeugen, enthält und erste Chromophore (10), die einen grünen Farbeindruck erzeugen, und zweite Chromophore (11), die einen roten Farbeindruck erzeugen, umfasst,und
wobei das Emittermaterial geeignet ist, elektromagnetische Strahlung zu erzeugen, dessen Spektrum durch den Anteil der jeweiligen Chromophore (10,11,12) so auf das Transmissionsspektrum des Farbfilters (6) abgestimmt ist, dass die Pixel (1) bei Ansteuerung mit einem gleichen elektrischen Signal Licht aussenden, dessen Farbort im weißen Bereich des CIE-Diagramms liegt, und
- einer zweiten Elektrode (7, 9) nachfolgend auf die aktive Schicht (8).

2. Organische Anzeige nach Anspruch 1, deren erste Elektrode (7, 9) eine Anode ist und die ITO umfasst.

3. Organische Anzeige nach einem der obigen Ansprüche, bei der die aktive Schicht (8) Polyspiroverbindungen enthält.

4. Organische Anzeige nach einem der obigen Ansprüche, bei der die aktive Schicht (8) Polyfluorenverbindungen enthält.

5. Organische Anzeige nach einem der obigen Ansprüche, bei der erste Chromophore (10) und zweite Chromophore (11) kovalent an das Polymer angebunden sind.

6. Organische Anzeige nach Anspruch 5, bei der das Emittermaterial weiß emittierende Copolymere enthält, die durch ein blau emittierendes Polymer, an das die ersten und zweiten Chrompohore kovalent gebunden sind, erzeugt werden.

7. Organische Anzeige nach einem der Ansprüche 1 bis 4, bei der erste Chromophore (10) und zweite Chromophore (11) mit dem Polymer vermischt sind.

8. Organische Anzeige nach einem der obigen Ansprüche, bei der die einzelnen Subpixel (2, 3, 4) des Subpixel-Satzes die gleiche Lebensdauer haben.

9. Verwendung einer organischen Anzeige mit Farbfiltertechnologie (6) nach einem der obigen Ansprüche in der Elektronik.

10. Verwendung einer organischen Anzeige mit Farbfiltertechnologie (6) nach einem der obigen Ansprüche für Beleuchtungszwecke mit einstellbarer Farbe.

## Claims

1. A colored organic display (OLED display) having pixels (1) each comprising a set of subpixels (2, 3, 4) having the colors red, green and blue, wherein the individual subpixels (2, 3, 4) contain an identical emitter material, comprising:
- a substrate (5) which is at least partially transparent to visible light,
- a structured color filter (6) which generates the colors of the subpixels (2, 3, 4) and is subsequent to the substrate (5),
- a first electrode (7, 9) which is subsequent to the color filter (6) and is at least partially transparent to visible light,
- at least one active layer (8) which is subsequent to the first electrode (7, 9) and contains the emitter material, wherein the emitter material contains polymers having chromophores (12) that produce a blue color impression, and comprises first chromophores (10) that produce a green color impression and second chromophores (11) that produce a red color impression, and
wherein the emitter material is suitable for generating electromagnetic radiation, whose spectrum is matched to the transmission spectrum of the color filter (6) by the fractions of the respective chromophores (10, 11, 12) in such a way that when driven by an identical electrical signal, the pixels (1) emit light, whose the color location is in the white region of the CIE diagram, and
- a second electrode (7, 9) subsequent to the active layer (8) .

2. The organic display according to claim 1, whose first electrode (7, 9) is an anode and comprises ITO.

3. The organic display according to one of the above claims, wherein the active layer (8) contains polyspiro compounds.

4. The organic display according to one of the above claims, wherein the active layer (8) contains polyfluorene compounds.

5. The organic display according to one of the above claims, wherein first chromophores (10) and second chromophores (11) are covalently bonded to the polymer.

6. The organic display according to claim 5, wherein the emitter material contains white emitting copolymers formed by a blue emitting polymer to which the first and second chromophores are covalently bonded.

7. The organic display according to any of claims 1 to 4, wherein first chromophores (10) and second chromophores (11) are mixed with the polymer.

8. The organic display according to one of the above claims, wherein the individual subpixels (2, 3, 4) of the set of subpixels have the same lifetime.

9. Use of an organic display with color filter technology (6) according to one of the above claims in electronics.

10. Use of an organic display with color filter technology (6) according to one of the above claims for illumination purposes with adjustable color.

## Revendications

1. Afficheur organique en couleur (écran OLED) comportant des pixels (1) qui comprennent chacun un ensemble de sous-pixels (2, 3, 4) de couleurs rouge, vert et bleu, les différents sous-pixels (2, 3, 4) contenant un matériau emetteur identique, comportant :
- un substrat (5) qui est au moins partiellement transparent pour la lumière visible,
- un filtre de couleurs (6) générant les couleurs des sous-pixels (2, 3, 4) et disposé en aval du substrat (5),
- une première électrode (7, 9) en aval du filtre de couleurs (6) qui est au moins partiellement transparente pour la lumière visible,
- au moins une couche active (8) en aval de la première électrode (7, 9) qui contient le matériau émetteur, le matériau émetteur contenant des polymères avec des chromophores (12) générant l'impression de couleur bleue, et des premiers chromophores (10) générant l'impression de couleur verte, et des seconds chromophores (11) générant
l'impression de couleur rouge, le matériau émetteur étant adapté pour générer un rayonnement électromagnétique dont le spectre est adapté, grâce à la proportion des chromophores correspondants (10, 11, 12), au spectre de transmission du filtre de couleurs (6) de sorte que les pixels (1), lorsqu'ils sont amorcés par un même signal électrique, émettent une lumière dont le lieu de couleur se trouve dans le spectre blanc du diagramme CIE, et
- une seconde électrode (7, 9) en aval de la couche active (8).

2. Afficheur organique selon la revendication 1,
dont la première électrode (7, 9) est une anode et comprend l'ITO.

3. Afficheur organique selon l'une quelconque des revendications précédentes, dans lequel la couche active (8) contient des composés poly-spiro.

4. Afficheur organique selon l'une quelconque des revendications précédentes, dans lequel la couche active (8) contient des composés de polyfluorène.

5. Afficheur organique selon l'une quelconque des revendications précédentes, dans lequel des premiers chromophores (10) et des seconds chromophores (11) sont liés de manière covalente au polymère.

6. Afficheur organique selon la revendication 5, dans lequel le matériau émetteur contient des copolymères émettant du blanc qui sont générés par un polymère émettant du bleu auquel sont liés de façon covalente les premiers et seconds chromophores.

7. Afficheur organique selon l'une quelconque des revendications 1 à 4, dans lequel des premiers chromophores (10) et des seconds chromophores (11) sont mélangés au polymère.

8. Afficheur organique selon l'une quelconque des revendications précédentes, dans lequel les différents sous-pixels (2, 3, 4) du jeu de sous-pixels ont la même durée de vie.

9. Utilisation dans le secteur électronique d'un afficheur organique mettant en oeuvre la technologie de filtre couleur (6) selon l'une des revendications précédentes.

10. Utilisation d'un afficheur organique mettant en oeuvre la technologie de filtre couleur (6) selon l'une des revendications précédentes pour des fins d'illumination avec couleur réglable.
